# EUROPÄISCHE PATENTSCHRIFT

(11) **EP 1 754 075 B1**
(45) Veröffentlichungstag und Bekanntmachung des Hinweises auf die Patenterteilung: **27.02.2008**
(21) Anmeldenummer: 05752747.5
(22) Anmeldetag: 24.05.2005
(51) Int. Cl.: G01R 31/3185

(54) **TESTVERFAHREN UND TESTVORRICHTUNG ZUM TESTEN EINER INTEGRIERTEN SCHALTUNG**
TEST METHOD AND TEST DEVICE FOR TESTING AN INTEGRATED CIRCUIT
PROCEDE ET DISPOSITIF DE TEST DESTINES A TESTER UN CIRCUIT INTEGRE

(30) Priorität: 08.06.2004 DE 102004027860
(43) Veröffentlichungstag der Anmeldung: 21.02.2007
(73) Patentinhaber: Siemens VDO Automotive AG, 93056 Regensburg (DE)
(72) Erfinder: BUCHNER, Reinhard, 84056 Rottenburg (DE); EBNER, Christian, 94469 Deggendorf (DE); MOSEL, Stefan, 93049 Regensburg (DE); RAUSCHER, Peter, 94356 Kirchroth (DE); VOIGTLÄNDER, Arndt, 93138 Lappersdorf (DE)
(86) Internationale Anmeldenummer: PCT/EP2005/052365
(87) Internationale Veröffentlichungsnummer: WO 2005/121828

(56) Entgegenhaltungen:
- US-A- 5 349 587
- US-B1- 6 314 539

## Beschreibung

Die Erfindung betrifft ein Testverfahren und eine Testvorrichtung zum Testen einer integrierten Schaltung.

Das technische Gebiet der Erfindung betrifft das Boundary-Scan-Testen von integrierten Schaltungen (Boundary-Scan bedeutet "Randprüfen"). Das Boundary-Scan-Testen ist eine allgemein bekannte Technik zum Testen komplizierter Digitalschaltungen. Boundary-Scan-Testen realisiert eine elektrische Prüfmethode zum Aufdecken fertigungsbedingter Verbindungsfehler (Kurzschlüsse durch Lotbrücken oder Leitungsunterbrechungen).
Der ANSI/IEEE-Standard 1149.1 wurde entwickelt, um einen kommerziellen Standard für Boundary-Scan-Testen bereitzustellen. Der Standard ist weithin von Herstellern integrierter Schaltungen akzeptiert worden.

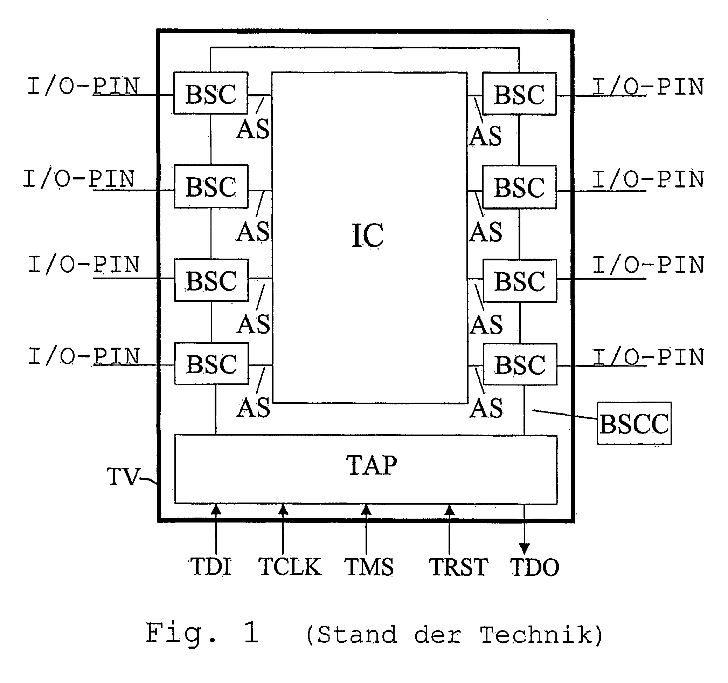

Das schematische Blockschaltbild nach Fig. 1 zeigt eine allgemein bekannte Testvorrichtung zum Boundary-Scan-Testen einer integrierten Schaltung. Der Test auf Verbindungsfehler wird durch die Schaffung virtueller Prüfpunkte in einer gemäß dem IEEE 1149.1 Standard entworfenen Testvorrichtung TV realisiert. Jeder Außenanschluss I/O-PIN der integrierten Schaltung IC wird intern mit einer einfachen Zusatzschaltung versehen, welche als Boundary-Scan-Zelle BSC bezeichnet wird. Alle Boundary-Scan-Zellen BSC sind seriell zu einer Kette BSCC (Boundary-Scan-Cell-Chain) verknüpft, welche die gesamte Außenanschlussstruktur I/O-Pin der Testvorrichtung TV umfasst.

Die US 5 349 587 (Nadeau-Dostie et al) beschreibt ein Testverfahren zum testen einer integrierten Schaltung wobei die Speicherelemente Rekonfigurierbar und in Scan Modus umschaltbar sind.

Die Implementierung eines Boundary-Scan-Verfahrens setzt voraus, dass die Testvorrichtung TV über vier eigens reservierte Steuerungs- und Daten-Pins verfügt. Dies sind der Testdaten-Eingang TDI und der Testdaten-Ausgang TDO, ein Testtakt TCLK, welcher typisch bis zu 15MHz betragen kann, und ein Test-Mode-Select-Anschluss TMS. Optional kann als fünfter Pin ein Test-Logik-Reset TRST hinzukommen, mit dem sich die Scan-Control-Logik bzw. die Kette BSCC der Boundary-Scan-Zellen BSC in einen definierten Zustand versetzen lässt. Diese Pins ergeben gemeinsam mit der von der jeweiligen Verschaltung der integrierten Schaltung IC abhängigen Scan-Logik den Test-Zugangs-Port TAP (Test Access Port).

Nachteiligerweise wird für die Boundary-Scan-Zellen BSC innerhalb der Testvorrichtung TV Platz benötigt. Ein hoher Platzbedarf ist bei integrierten Schaltungen mit hohen Kosten verbunden, so dass hier immer die Tendenz hin zu einer Reduzierung des Platzbedarfs geht. Verringert man den Platzbedarf der Testvorrichtung TV, so werden auch die Kosten für die Testvorrichtung TV verringert. Das Testen integrierter Schaltungen wird damit kostengünstiger.

Der vorliegenden Erfindung liegt daher die Aufgabe zugrunde, für ein Testen einer integrierten Schaltung Platz einzusparen.

Erfindungsgemäß wird diese Aufgabe durch ein Testverfahren mit den Merkmalen des Patentanspruchs 1 sowie durch eine Testvorrichtung mit den Merkmalen des Patentanspruchs 9 gelöst. Demgemäß sind vorgesehen:

Ein Testverfahren zum Testen einer integrierten Schaltung gemäß einer Boundary-Scan-Beschreibung, welche zumindest ein Boundary-Scan-Programm, einen hardwaretechnischen Verschaltungsplan der integrierten Schaltung und ein Testmuster aufweist, wobei die integrierte Schaltung einen Speicher und eine Vielzahl von Anschlussstiften aufweist und mittels einer programmgesteuerten Steuervorrichtung steuerbar ist, mit den Schritten:
- Laden des Boundary-Scan-Programms, welches eine Nachbildung einer Kette von Boundary-Scan-Zellen ausbildet, über wenigstens einen vorbestimmten Anschlussstift in den Speicher;
- Auslesen und Starten der Ausführung des gespeicherten Boundary-Scan-Programms;
- Anlegen des Testmusters gemäß der Boundary-Scan-Beschreibung für vorbestimmte Anschlussstifte, welche dem TAP-Interface entsprechen; und
- Auswerten der sich nach der Ausführungs des gespeicherten Boundary-Scan-Programm ergebenden Zustände an den Anschlussstiften. (Patentanspruch 1)

Eine Testvorrichtung, insbesondere zum Betreiben des Testverfahrens,
- mit einer Vielzahl von Außenanschlüssen, über welche das Testmuster gemäß der Boundary-Scan-Beschreibung angelegt wird, wobei jeweils ein Außenanschluss mit genau einem Anschlussstift der integrierten Schaltung verbunden ist;
- mit der integrierten Schaltung, welche einen Speicher, in den das Boundary-Scan-Programm geladen wird, und eine Vielzahl von Anschlussstiften aufweist; und
- mit einer programmgesteuerten Steuervorrichtung, welche das Boundary-Scan-Programm aus dem Speicher ausliest, dessen Ausführung startet und die sich nach der Ausführung des gespeicherten Boundary-Scan-Programms ergebenden Zustände an den Anschlussstiften einliest und das Ergebnis an einen oder mehreren Anschlussstiften (4) ausgibt. (Patentanspruch 9)

Die der vorliegenden Erfindung zugrunde liegende Idee besteht im Wesentlichen darin, ein Testverfahren und eine Testvorrichtung zum Testen einer integrierten Schaltung gemäß einer Boundary-Scan-Beschreibung bereitzustellen, wobei auf ein hardwaretechnisches Vorsehen der Boundary-Scan-Zellen verzichtet wird. Dagegen werden die Boundary-Scan-Zellen erfindungsgemäß durch das Boundary-Scan-Programm nachgebildet.

Sämtliche Funktionalitäten der Kette an Boundary-Scan-Zellen sind durch den Einsatz des Boundary-Scan-Programms erfüllt. Ebenso erfüllen die vorbestimmten Anschlussstifte die Funktionalitäten des bekannten TAP-Interfaces.

Vorteilhafterweise wird durch das Weglassen der hardwaretechnischen Boundary-Scan-Zellen Platz innerhalb der Testvorrichtung eingespart. Durch die Platzeinsparung spart der Hersteller integrierter Schaltungen immense Kosten ein.

Ferner gehört zum Umfang der Erfindung ein Computerprogramm, das bei Ablauf auf einem Computer oder Computer-Netzwerk das erfindungsgemäße Verfahren in einer seiner Ausgestaltungen ausführt.

Weiterhin gehört zum Umfang der Erfindung ein Computerprogramm mit Programmcode-Mitteln, um das erfindungsgemäße Verfahren in einer seiner Ausgestaltungen durchzuführen, wenn das Programm auf einem Computer oder Computer-Netzwerk ausgeführt wird. Insbesondere können die Programmcode-Mittel auf einem computerlesbaren Datenträger gespeichert sein.

Außerdem gehört zum Umfang der Erfindung ein Datenträger, auf dem eine Datenstruktur gespeichert ist, die nach einem Laden in einen Arbeits- und/oder Hauptspeicher eines Computers oder Computer-Netzwerkes das erfindungsgemäße Verfahren in einer seiner Ausgestaltungen ausführen kann.

Auch gehört zum Umfang der Erfindung ein Computerprogramm-Produkt mit auf einem maschinenlesbaren Träger gespeicherten Programmcode-Mitteln, um das erfindungsgemäße Verfahren in einer seiner Ausgestaltungen durchzuführen, wenn das Programm auf einem Computer oder Computer-Netzwerk ausgeführt wird.

Dabei wird unter einem Computer-Programmprodukt das Programm als handelbares Produkt verstanden. Es kann grundsätzlich in beliebiger Form vorliegen, so zum Beispiel auf Papier oder einem computerlesbaren Datenträger, und kann insbesondere über ein Datenübertragungsnetz verteilt werden.

Vorteilhafte Ausgestaltungen und Weiterbildungen der Erfindung sind in den Unteransprüchen sowie der Beschreibung unter Bezugnahme auf die Zeichnung entnehmbar.

Gemäß einer bevorzugten Weiterbildung beinhaltet das Anlegen des Testmusters gemäß der Boundary-Scan-Beschreibung an vorbestimmte Anschlussstifte, dass ein Laden des Testmusters gemäß der Boundary-Scan-Beschreibung an vorbestimmte Anschlussstifte in den Speicher und ein Anlegen von mittels des gespeicherten Testmusters definierten Zuständen an die Anschlussstifte mittels des Boundary-Scan-Programms erfolgen. Somit können Zustände des Testmusters nicht nur von außen über die Außenanschlüsse und Anschlussstifte angelegt werden, sondern die Testmuster können auch in den Speicher geladen werden und mittels des Boundary-Scan-Programms an die Anschlussstifte angelegt werden. Vorteilhafterweise sind somit zwei verschiedene Möglichkeiten vorgesehen, bestimmte Zustände des Testmusters anzulegen.

Gemäß einer weiteren bevorzugten Weiterbildung wird die Boundary-Scan-Beschreibung nach dem IEEE 1149.1-Standard ausgebildet. Die Boundary-Scan-Beschreibung weist demnach die Merkmale einer herkömmlichen BSDL-Datei (Boundary Scan Description Language) sowie das erfindungsgemäße Boundary-Scan-Programm auf.

Gemäß einer weiteren bevorzugten Weiterbildung wird das Boundary-Scan-Programm abhängig von dem hardwaretechnischen Verschaltungsplan der jeweiligen integrierten Schaltung und von der Boundary-Scan-Beschreibung ausgebildet.

Gemäß einer weiteren bevorzugten Weiterbildung werden die gemäß dem IEEE 1149.1-Standard definierten Boundary-Scan-Zellen mittels des Boundary-Scan-Programms virtuell nachgebildet.

Dadurch, dass auf die hardwaretechnischen Boundary-Scan-Zellen verzichtet wird, werden Siliciumfläche und somit Kosten eingespart.

Gemäß einer bevorzugten Ausgestaltung wird das Auswerten der Zustände an den Anschlussstiften durch ein Abgreifen jeweils eines elektrische Potenzials an mit einer vorbestimmten Auswahl der Anschlussstifte gekoppelten Prüfpunkten durchgeführt. Vorteilhafterweise werden die Außenanschlüsse verwendet, zu welchen von außen ein direkter Zugang besteht. Vorteilhafterweise ist es für das erfindungsgemäße Testverfahren nicht notwendig, jeweils das elektrische Potenzial an allen Anschlussstiften abzugreifen.

Gemäß einer weiteren bevorzugten Ausgestaltung wird für das Auswerten der Zustände an den Anschlussstiften die zu testende integrierte Schaltung über ihre Anschlussstifte mit wenigstens einer weiteren integrierten Schaltung oder einem analogen transparenten Bauelement, wie z.B. einem Widerstand oder einer Spule, gekoppelt, und dann werden die Zustände an den Anschlussstiften der zu testenden integrierten Schaltung über eine mit ihre gekoppelten weiteren integrierten Schaltung oder einem analogen transparente Bauelement bestimmt. Die weiteren integrierten Schaltungen können erfindungsgemäß keine oder herkömmliche Boundary-Scan-Zellen aufweisen. Durch das Verbinden mehrerer integrierter Schaltungen werden die Testmöglichkeiten verbessert.

Gemäß einer weiteren bevorzugten Ausgestaltung wird das Laden des Boundary-Scan-Programms in den Speicher über eine synchrone, asynchrone oder Bus-Schnittstelle - beispielsweise eine CAN-Bus-Schnittstelle - der integrierten Schaltung durchgeführt.

Die Erfindung wird nachfolgend anhand der in den schematischen Figuren der Zeichnungen angegebenen Ausführungsbeispielen näher erläutert. Es zeigen:
- Fig. 1: ein schematisches Blockschaltbild einer allgemein bekannten Testvorrichtung zum Testen einer integrierten Schaltung;
- Fig. 2: ein schematisches Blockschaltbild eines ersten Ausführungsbeispiels einer erfindungsgemäßen Testvorrichtung zum Testen einer integrierten Schaltung; und
- Fig. 3: ein schematisches Ablaufdiagramm eines ersten Ausführungsbeispiels eines erfindungsgemäßen Testverfahrens zum Testen einer integrierten Schaltung.

In allen Figuren der Zeichnungen sind gleiche oder funktionsgleiche Elemente - sofern nichts anderes angegeben - mit denselben Bezugszeichen versehen worden.

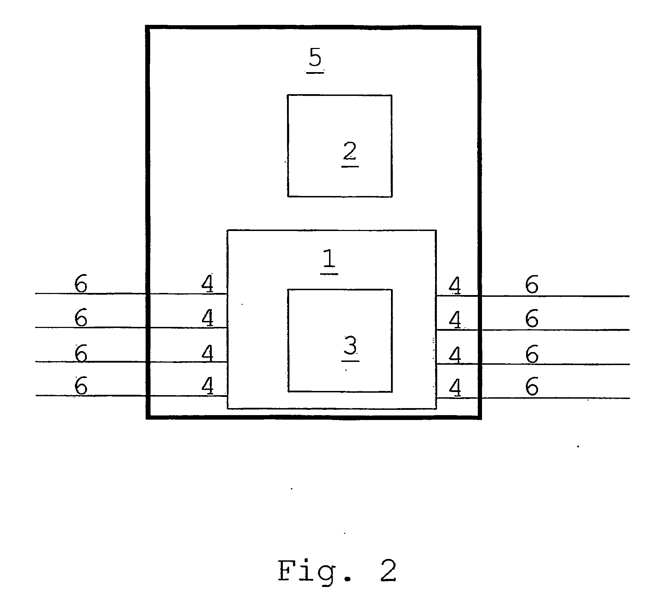

Fig. 2 zeigt ein schematisches Blockschaltbild eines ersten Ausführungsbeispiels einer erfindungsgemäßen Testvorrichtung zum Testen einer integrierten Schaltung. In der Testvorrichtung 5 ist eine integrierte Schaltung 1 vorgesehen, welche einen Speicher 3 und eine Vielzahl von Anschlussstiften 4 aufweist. Weiter weist die Testvorrichtung 5 eine programmgesteuerte Steuervorrichtung 2 auf, welche die integrierte Schaltung 1 steuert.

Über vorbestimmte Außenanschlüsse 6 wird das Boundary-Scan-Programm in den Speicher 3 geladen. Das Boundary-Scan-Programm bildet eine Nachbildung einer Kette von Boundary-Scan-Zellen aus. Die programmgesteuerte Steuervorrichtung 2 liest das Boundary-Scan-Programm aus dem Speicher 3 aus und startet dessen Ausführung. Über eine Vielzahl der Außenanschlüsse 6 wird das Testmuster gemäß der Boundary-Scan-Beschreibung an vorbestimmte Anschlussstifte 4 angelegt. Dabei kann das Testmuster entweder an vorbestimmten Anschlussstiften 4 direkt angelegt werden oder das Testmuster wird vorerst in den Speicher 3 geladen. Dann werden mittels des Boundary-Scan-Programms definierte Zustände des gespeicherten Testmusters intern an andere vorbestimmte Anschlussstifte 4 angelegt. Die programmgesteuerte Steuervorrichtung 2 wertet die sich nach der Ausführung des gespeicherten Boundary-Scan-Programms ergebenden Zustände an den Anschlussstiften 4 aus. Die Zustände können beispielsweise binäre Zustände sein.

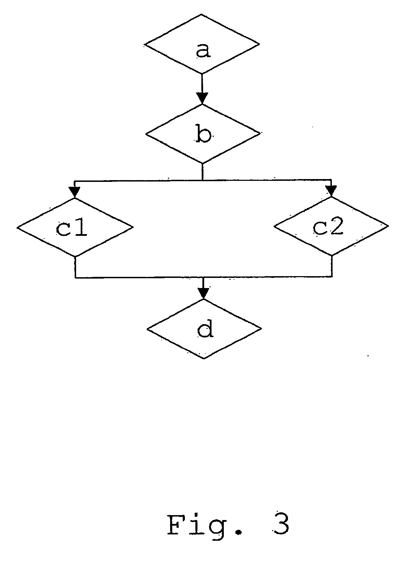

In Fig. 3 ist ein schematisches Ablaufdiagramm eines ersten Ausführungsbeispiels eines erfindungsgemäßen Testverfahrens zum Testen einer integrierten Schaltung dargestellt. Das Testverfahren zum Testen der integrierten Schaltung wird gemäß einer Boundary-Scan-Beschreibung durchgeführt. Die Boundary-Scan-Beschreibung weist zumindest ein Boundary-Scan-Programm, einen hardwaretechnischen Verschaltungsplan der integrierten Schaltung 1 und ein Testmuster auf, wobei die integrierte Schaltung 1 einen Speicher 3 und eine Vielzahl von Anschlussstiften 4 aufweist und mit einer programmgesteuerten Steuervorrichtung 2 steuerbar ist. Das erfindungsgemäße Testverfahren beinhaltet folgende Verfahrensschritte:
Verfahrensschritt a:
   Das Boundary-Scan-Programm, welches eine Nachbildung einer Kette von Boundary-Scan-Zellen ausbildet, wird über wenigstens einen vorbestimmten Anschlussstift 4 in den Speicher 3 geladen. Das Boundary-Scan-Programm wird vorzugsweise abhängig von dem hardwaretechnischen Verschaltungsplan der integrierten Schaltung 1 und von der Boundary-Scan-Beschreibung ausgebildet. Vorteilhafterweise werden die gemäß dem IEEE 1149.1-Standard definierten Boundary-Scan-Zellen mittels des Boundary-Scan-Programms virtuell nachgebildet. Weiter wird das Laden des Boundary-Scan-Programms in den Speicher 3 vorzugsweise über eine serielle (SPI)-Schnittstelle oder eine CAN-Schnittstelle der integrierten Schaltung 1 durchgeführt.
Verfahrensschritt b:
   Das Boundary-Scan-Programm wird aus dem Speicher ausgelesen und dessen Ausführung wird gestartet.
   Die nachfolgenden Verfahrensschritte c1 und c2 stellen zwei Alternativen für das Anlegen des Testmusters dar.
Verfahrensschritt c1:
   Das Testmuster wird gemäß der Boundary-Scan-Beschreibung direkt über vorbestimmte Außenanschlüsse 6 an die mit diesen vorbestimmten Außenanschlüssen 6 gekoppelten Anschlussstiften 4 angelegt.
Verfahrensschritt c2:
   Alternativ zu dem direkten Anlegen des Testmusters an vorbestimmte Anschlussstifte 4 kann das Anlegen des Testmusters gemäß der Boundary-Scan-Beschreibung an vorbestimmte Anschlussstifte 4 auch beinhalten, vorerst das Testmuster in den Speicher 3 zu laden und durch das gespeicherte Testmuster definierte Zustände an Anschlussstifte 4 mittels des Boundary-Scan-Programms anzulegen. Vorzugsweise ist die Boundary-Scan-Beschreibung nach dem IEEE 1149.1-Standard ausgebildet.
Verfahrensschritt d:
   Die sich nach der Ausführung des gespeicherten Boundary-Scan-Programms ergebenden Zustände an den Anschlussstiften 4 werden ausgewertet. Mittels dieser Auswertung kann detektiert werden, ob und wo Verbindungsfehler (Kurzschlüsse durch Lotbrücken oder Leitungsunterbrechungen) innerhalb der Verschaltung der integrierten Schaltung 1 existieren. Das Auswerten der Zustände an den Anschlussstiften 4 wird vorzugsweise durch ein Abgreifen jeweils eines elektrischen Potenzials an mit einer vorbestimmten Auswahl der Anschlussstifte 4 gekoppelten Außenanschlüssen 6 durchgeführt. Alternativ wird für das Auswerten der Zustände an den Anschlussstiften 4 die zu testende integrierte Schaltung 1 über ihre Anschlussstifte 4 mit wenigstens einer weiteren integrierten Schaltung gekoppelt. Dann werden die Zuständen an den Anschlussstiften 4 der zu testenden integrierten Schaltung 1 über eine mit ihr gekoppelten weiteren integrierten Schaltung bestimmt. Die weiteren integrierten Schaltungen können erfindungsgemäß keine oder herkömmliche Boundary-Scan-Zellen aufweisen. Durch das Verbinden mehrerer integrierter Schaltungen werden die Testmöglichkeiten für das Boundary-Scan-Testen verbessert, da die Anzahl der von außen zu erreichenden Anschlussstifte 4 steigt.

Obwohl die vorliegende Erfindung vorstehend anhand bevorzugter Ausführungsbeispiele beschrieben wurde, ist sie darauf nicht beschränkt, sondern auf vielfältige Art und Weise modifizierbar. Beispielsweise ist die Auswahl der Schnittstelle, über welche das Boundary-Scan-Programm geladen wird, je nach der Bauart der integrierten Schaltung frei wählbar.

## Patentansprüche

1. Testverfahren zum Testen einer integrierten Schaltung (1) gemäß einer Boundary-Scan-Beschreibung, welche zumindest ein Boundary-Scan-Programm, einen hardwaretechnischen Verschaltungsplan der integrierten Schaltung (1) und ein Testmuster aufweist, wobei die integrierte Schaltung (1) einen Speicher (3) und eine Vielzahl von Anschlussstiften (4) aufweist und mittels einer programmgesteuerten Steuervorrichtung (2) steuerbar ist, mit den Schritten:
- Laden des Boundary-Scan-Programms, welches eine Nachbildung einer Kette von Boundary-Scan-Zellen ausbildet, über wenigstens einen vorbestimmten Anschlussstift (4) in den Speicher (3);
- Auslesen und Starten der Ausführung des gespeicherten Boundary-Scan-Programms;
- Anlegen des Testmusters gemäß der Boundary-Scan-Beschreibung an vorbestimmte Anschlussstifte (4); und
- Auswerten der sich nach der Ausführung des gespeicherten Boundary-Scan-Programms ergebenden Zustände an den Anschlussstiften (4).

2. Testverfahren nach Anspruch 1,
**dadurch gekennzeichnet,**
**dass** das Anlegen des Testmusters gemäß der Boundary-Scan-Beschreibung an vorbestimmte Anschlussstifte (4) beinhaltet: Laden des Testmusters gemäß der Boundary-Scan-Beschreibung über vorbestimmte Anschlussstifte (4) in den Speicher (3) und Anlegen von mittels des gespeicherten Testmusters definierten Zuständen an die Anschlussstifte (4) mittels des Boundary-Scan-Programms.

3. Testverfahren nach einem der vorstehenden Ansprüche,
**dadurch gekennzeichnet,**
**dass** die Boundary-Scan-Beschreibung nach dem IEEE 1149.1 Standard ausgebildet ist.

4. Testverfahren nach einem der vorstehenden Ansprüche,
**dadurch gekennzeichnet,**
**dass** das Boundary-Scan-Programm abhängig von dem hardwaretechnischen Verschaltungsplan der integrierten Schaltung (1) und von der Boundary-Scan-Beschreibung ausgebildet ist.

5. Testverfahren nach einem der vorstehenden Ansprüche,
**dadurch gekennzeichnet,**
**dass** die gemäß dem IEEE 1149.1 Standard definierten Boundary-Scan-Zellen mittels des Boundary-Scan-Programms virtuell nachgebildet werden.

6. Testverfahren nach einem der vorstehenden Ansprüche,
**dadurch gekennzeichnet,**
**dass** das Auswerten der Zustände an den Anschlussstiften (4) durch ein Abgreifen jeweils eines elektrischen Potenzials an mit einer vorbestimmten Auswahl der Anschlussstifte (4) gekoppelten Außenanschlüssen (6) durchgeführt wird.

7. Testverfahren nach einem der vorstehenden Ansprüche,
**dadurch gekennzeichnet,**
**dass** für das Auswerten der Zustände an den Anschlussstiften (4) die zu testende integrierte Schaltung (1) über ihre Anschlussstifte (4) mit wenigstens einer weiteren integrierten Schaltung oder einem analogen transparenten Bauelement gekoppelt wird und dass dann die Zustände an den Anschlussstiften (4) der zu testenden integrierten Schaltung (1) über eine mit ihr gekoppelten weiteren integrierten Schaltung oder einem analogen transparente Bauelement bestimmt werden.

8. Testverfahren nach einem der vorstehenden Ansprüche,
**dadurch gekennzeichnet,**
**dass** das Laden des Boundary-Scan- in den Speicher über eine synchrone, asynchrone oder CAN Schnittstelle der integrierten Schaltung (1) durchgeführt wird.

9. Testvorrichtung (5), zum Betreiben aller Schritte eines Testverfahrens nach einem der vorangegangenen Ansprüche,
- mit einer Vielzahl von Außenanschlüssen (6), über welche das Testmuster gemäß der Boundary-Scan-Beschreibung angelegt wird, wobei jeweils ein Außenanschluss (6) mit genau einem Anschlusstift (4) verbunden ist;
- mit einer integrierten Schaltung (1), welche einen Speicher (3), in den das Boundary-Scan-Programm geladen wird, und eine Vielzahl von Anschlussstiften (4) aufweist; und
- mit einer programmgesteuerten Steuervorrichtung (2), welche das Boundary-Scan-Programm aus dem Speicher (3) ausliest, dessen Ausführung startet und die sich nach der Ausführung des gespeicherten Boundary-Scan-Programms ergebenden Zustände an den Anschlussstiften (4) einliest und das Ergebnis an einen oder mehreren Anschlussstiften (4) ausgibt.

10. Computerprogramm mit Programmcode-Mitteln, um ein Verfahren gemäß einem der Ansprüche 1 bis 8 durchzuführen, wenn das Programm auf einem Computer oder Computer-Netzwerk ausgeführt wird.

11. Computerprogramm mit Programmcode-Mitteln gemäß dem vorhergehenden Anspruch, die auf einem computerlesbaren Datenträger gespeichert sind.

12. Datenträger, auf dem eine Datenstruktur gespeichert ist, die nach einem Laden in einen Arbeits- und/oder Hauptspeicher eines Computers oder Computer-Netzwerkes das Verfahren nach einem der Ansprüche 1 bis 8 ausführt.

13. Computerprogramm-Produkt mit auf einem maschinenlesbaren Träger gespeicherten Programmcode-Mitteln, um alle Schritte gemäß den Ansprüchen 1 bis 8 durchzuführen, wenn das Programm auf einem Computer oder Computer-Netzwerk ausgeführt wird.

## Claims

1. Test method for testing an integrated circuit (1) according to a boundary scan description, having at least a boundary scan program, a hardware-related wiring plan of the integrated circuit (1) and a test specimen, the integrated circuit (1) having a memory (3) and a plurality of terminal pins (4) and being able to be controlled by means of a program-controlled control device (2), with the steps:
- loading the boundary scan program, which configures a simulation of a chain of boundary scan cells, into the memory (3) by way of at least one predetermined terminal pin (4);
- reading out and starting the execution of the stored boundary scan program;
- applying the test specimen according to the boundary scan description to predetermined terminal pins (4) and
- evaluating the states resulting at the terminal pins (4) after execution of the stored boundary scan program.

2. Test method according to claim 1,
**characterised in that**
the application of the test specimen according to the boundary scan description to predetermined terminal pins (4) involves: loading the test specimen according to the boundary scan description into the memory (3) by way of predetermined terminal pins (4) and applying states defined by means of the stored test specimen to the terminal pins (4) by means of the boundary scan program.

3. Test method according to one of the preceding claims,
**characterised in that**
the boundary scan description is configured according to the IEEE 1149.1 standard.

4. Test method according to one of the preceding claims,
**characterised in that**
the boundary scan program is configured as a function of the hardware-related wiring plan of the integrated circuit (1) and the boundary scan description.

5. Test method according to one of the preceding claims,
**characterised in that**
the boundary scan cells defined according to the IEEE 1149.1 standard are simulated virtually by means of the boundary scan program.

6. Test method according to one of the preceding claims,
**characterised in that**
the states at the terminal pins (4) are evaluated by picking off an electric potential respectively at external terminals (6) coupled to a predetermined selection of terminal pins (4).

7. Test method according to one of the preceding claims,
**characterised in that**
to evaluate the states at the terminal pins (4), the integrated circuit (1) to be tested is coupled by way of its terminal pins (4) to at least one further integrated circuit or a similar transparent component and the states at the terminal pins (4) of the integrated circuit (1) to be tested are then determined by way of a further integrated circuit coupled to it or a similar transparent component.

8. Test method according to one of the preceding claims,
**characterised in that**
the boundary scan is loaded into the memory by way of a synchronous, asynchronous or CAN interface of the integrated circuit (1).

9. Test device (5), for operating all steps of a test method according to one of the preceding claims,
- with a plurality of external terminals (6), by way of which the test specimen according to the boundary scan description is applied, an external terminal (6) being connected respectively to just one terminal pin (4);
- with an integrated circuit, having a memory (3), into which the boundary scan program is loaded, and a plurality of terminal pins (4) and
- with a program-controlled control device (2), which reads the boundary scan program from the memory (3), starts its execution and reads in the states resulting at the terminal pins (4) after execution of the stored boundary scan program and outputs the result to one or more terminal pins (4).

10. Computer program with program code means to implement a method according to one of claims 1 to 8, when the program is executed on a computer or computer network.

11. Computer program with program code means according to the preceding claim, stored on a computer-readable data medium.

12. Data medium, on which a data structure is stored, which, when loaded into a random-access and/or main memory of a computer or computer network, can execute the method according to one of claims 1 to 8.

13. Computer program product with program code means stored on a machine-readable medium, to implement all the steps according to claims 1 to 8, when the program is executed on a computer or computer network.

## Revendications

1. Procédé de test destiné à tester un circuit intégré (1) suivant une description boundary-scan comportant au moins un programme boundary-scan, un schéma des connexions matérielles du circuit intégré (1) et un modèle de test, ledit circuit intégré (1) comportant une mémoire (3) et une pluralité de broches de connexion (4) et pouvant être commandé au moyen d'un dispositif de commande par logiciel (2), comprenant les étapes suivantes:
- chargement en mémoire (3) du programme boundary-scan réalisant une simulation d'une chaîne de cellules boundary-scan, par au moins une broche de connexion (4) définie ;
- lecture et lancement de l'exécution du programme boundary-scan mémorisé ;
- application du modèle de test suivant la description boundary-scan sur des broches de connexion (4) définies ; et
- évaluation des états résultants sur les broches de connexion (4) après exécution du programme boundary-scan mémorisé.

2. Procédé de test selon la revendication 1,
**caractérisé**
**en ce que** l'application du modèle de test suivant la description boundary-scan sur des broches de connexion (4) définies implique : le chargement en mémoire (3) du modèle de test suivant la description boundary-scan par des broches de connexion (4) définies et l'application d'états définis par le modèle de test mémorisé sur les broches de connexion (4) au moyen du programme boundary-scan.

3. Procédé de test selon l'une des revendications précédentes,
**caractérisé**
**en ce que** la description boundary-scan est réalisée conformément à la norme IEEE 1149.1.

4. Procédé de test selon l'une des revendications précédentes,
**caractérisé**
**en ce que** le programme boundary-scan est réalisé en fonction du schéma des connexions matérielles du circuit intégré (1) et de la description boundary-scan.

5. Procédé de test selon l'une des revendications précédentes,
**caractérisé**
**en ce que** les cellules boundary-scan définies conformément à la norme IEEE 1149.1 sont virtuellement reproduites au moyen du programme boundary-scan.

6. Procédé de test selon l'une des revendications précédentes,
**caractérisé**
**en ce que** l'évaluation des états sur les broches de connexion (4) est exécutée par saisie d'un potentiel électrique correspondant sur des connexions externes (6) couplées à une sélection définie des broches de connexion (4).

7. Procédé de test selon l'une des revendications précédentes,
**caractérisé**
**en ce que** pour l'évaluation des états sur les broches de connexion (4), le circuit intégré (1) à tester est couplé par ses broches de connexion (4) à au moins un autre circuit intégré ou à un composant analogique transparent, et en ce que les états sur les broches de connexion (4) du circuit intégré (1) à tester sont alors déterminés par un autre circuit intégré ou par un composant analogique transparent couplé à celui-ci.

8. Procédé de test selon l'une des revendications précédentes,
**caractérisé**
**en ce que** le chargement en mémoire du programme boundary-scan est exécuté par un port synchrone, asynchrone ou CAN du circuit intégré (1).

9. Dispositif de test (5) pour la commande de toutes les étapes d'un procédé de test selon l'une des revendications précédentes,
- avec une pluralité de connexions externes (6) par lesquelles le modèle de test est appliqué suivant la description boundary-scan, chaque connexion externe (6) étant exactement raccordée à une broche de connexion (4) ;
- avec un circuit intégré (1) comportant une mémoire (3) dans laquelle le programme boundary-scan est chargé, et une pluralité de broches de connexion (4) ; et
- avec un dispositif de commande par logiciel (2) lisant le programme boundary-scan de la mémoire (3), lançant l'exécution de celui-ci et lisant les états résultants sur les broches de connexion (4) après exécution du programme boundary-scan mémorisé, et sortant le résultat sur une ou plusieurs broches de connexion (4).

10. Programme informatique avec des moyens de codage de programme, destiné à exécuter un procédé selon l'une des revendications 1 à 8 lorsque ledit programme est exécuté sur un ordinateur ou un réseau d'ordinateurs.

11. Programme informatique avec des moyens de codage de programme selon la revendication précédente, lesdits moyens étant mémorisés sur un support de données lisible par ordinateur.

12. Support de données sur lequel une structure de données est mémorisée, laquelle exécute le procédé selon l'une des revendications 1 à 8 après chargement dans une mémoire de travail et/ou une mémoire principale d'un ordinateur ou d'un réseau d'ordinateurs.

13. Produit avec programme informatique avec des moyens de codage de programme mémorisés sur un support lisible par machine, pour l'exécution de toutes les étapes selon les revendications 1 à 8 lorsque le programme est exécuté sur un ordinateur ou un réseau d'ordinateurs.
